(19) Europäisches Patentamt European Patent Office Office européen des brevets

(11) **EP 1 793 489 A1**

(12) **EUROPEAN PATENT APPLICATION**
published in accordance with Art. 158(3) EPC

(43) Date of publication:
06.06.2007 Bulletin 2007/23

(51) Int Cl.:
*H03B 5/18* (2006.01)    *H01P 7/08* (2006.01)

(21) Application number: 05768504.2

(22) Date of filing: 03.08.2005

(86) International application number:
PCT/JP2005/014207

(87) International publication number:
WO 2006/033204 (30.03.2006 Gazette 2006/13)

(84) Designated Contracting States:
AT BE BG CH CY CZ DE DK EE ES FI FR GB GR HU IE IS IT LI LT LU LV MC NL PL PT RO SE SI SK TR

(30) Priority: 21.09.2004 JP 2004273710

(71) Applicant: MURATA MANUFACTURING CO., LTD.
Nagaokakyo-shi, Kyoto 617-8555 (JP)

(72) Inventors:
• ICHIKAWA, Keiichi c/o Murata Manufacturing Co. Ltd
Nagaokakyo-shi, Kyoto 6178555 (JP)

• SASABATA, Akihiro c/o Murata Manufacturing Co. Ltd
Nagaokakyo-shi, Kyoto 6178555 (JP)

(74) Representative: Schoppe, Fritz et al
Schoppe, Zimmermann, Stöckeler & Zinkler
Patentanwälte
Postfach 246
82043 Pullach bei München (DE)

(54) **HIGH FREQUENCY OSCILLATION CIRCUIT AND TRANSMITTER/RECEIVER**

(57) A resonant circuit 9 includes a resonator 10 provided on the surface of a circuit board 2 and a main line 19 connected to a negative resistance circuit. The resonator 10 is structured such that a resonant electrode 12 is formed on a dielectric substrate 11, and a coupling electrode 17 coupled to the resonant electrode 12 is provided on the dielectric substrate 11. A branch line 21 extending toward the resonator 10 is added to a main line 19, and bonding wires 22 are used to connect between the leading end 21A of the branch line 21 and the coupling electrode 17. With this structure, it is possible to use the branch line 21 to shift an unnecessary resonant frequency due to the ground capacitance of the coupling electrode 17 and the inductance of the bonding wires 22 toward a frequency band lower than the resonant frequency of the resonator 10.

FIG. 2

**Description**

Technical Field

The present invention relates to a high-frequency oscillator circuit that oscillates high-frequency signals, such as microwaves or millimeter waves, and to a transmitter-receiver using the high-frequency oscillator circuit.

Background Art

A high-frequency oscillator circuit typically includes a resonant circuit that reflects a high-frequency signal having a predetermined frequency and a negative resistance circuit that is connected to the resonant circuit and that amplifies the high-frequency signal and outputs the amplified signal. The resonant circuit in the high-frequency oscillator circuit includes a resonator that resonates at a predetermined frequency and a main line, such as a microstrip line, which is provided between the negative resistance circuit and a terminating resistor and is coupled to the resonator. The resonant circuit selectively reflects a signal having a frequency near the resonant frequency of the resonator. The negative resistance circuit includes an active device, such as a transistor, and amplifies the high-frequency signal reflected by the resonant circuit. The high-frequency oscillator circuit oscillates at a frequency satisfying the phase condition and the amplitude condition between the resonant circuit and the negative resistance circuit.

As a first related art, an oscillator circuit which has a main line provided on a circuit board and in which a dielectric resonator formed of a column-shaped dielectric block is provided near the main line is known (for example, refer to Patent Document 1) . In this oscillator circuit, a certain resonant mode excited in the dielectric resonator is coupled to the main line. The dielectric resonator is mounted on the circuit board with a support table sandwiched therebetween.

Patent Document 1: Japanese Unexamined Patent Application Publication No. 6-204747

As a second related art, an oscillator circuit having a microstrip resonator formed on the same plane as a main line on a circuit board is known (for example, refer to Non-Patent Document 1) . In this oscillator circuit, arranging the main line adjacent to the microstrip resonator causes the main line to be coupled to the microstrip resonator.

Non-Patent Document 1: Young-Taek Lee et al., "A Compact-Size Microstrip Spiral Resonator and Its Application to Microwave Oscillator", IEEE MICROWAVE AND WIRELESS COMPONENTS LETTER, Oct.2000, Vol. 12, No. 10, p.375-377

As a third related art, an oscillator circuit which has a resonant electrode formed on the same plane as a main line on a circuit board and in which bonding wires are used to directly connect the main line to the resonant electrode is also known (for example, refer to Patent Document 2).

Patent Document 2: Japanese Unexamined Patent Application Publication No. 11-330818

As a fourth related art, an oscillator circuit in which a coupling capacitor is provided on a microstrip resonator and bonding wires are used to connect the coupling capacitor to a main line is also known (for example, refer to Patent Document 3).

Patent Document 3: Japanese Unexamined Patent Application Publication No. 63-70601

In the case of the above first related art, the dielectric resonator having a larger external dimension increases the size of the entire oscillator circuit. Since the resonant frequency is determined on the basis of the outline of the dielectric resonator, high-precision machine work is required. In order to reproduce the amount of coupling between the dielectric resonator and the main line, it is necessary to mount the dielectric resonator at a predetermined position on the circuit board with a high precision. In addition, since it is necessary to provide a mechanism for fixing the dielectric resonator on the circuit board, there are problems in that assembly of the oscillator circuit is complicated and the manufacturing cost is increased.

In the case of the second related art, since the main line and the microstrip resonator are formed on the circuit board, the dielectric material of the resonator is limited to the same material as that of the circuit board. A material having a relatively low relative dielectric constant (for example, $\varepsilon r$ = around 2 to 13) is used for the circuit board, thus increasing the size of the resonator. In contrast, the resonator is required to satisfy requirements of a high dielectric constant, a small loss, and superior temperature stability. Use of a material satisfying these requirements for the circuit board undesirably increases the cost of the circuit board.

In the case of the third related art, the same problems as in the second related art are caused. In addition, since the bonding wires are used to directly connect the main line to the resonant electrode in the third related art, there is also a problem in that the coupling between the main line and the resonator is strengthened and, therefore, a sharp reflection characteristic cannot be achieved.

In the case of the fourth related art, unnecessary resonance due to the inductance and the stray capacitance of the bonding wires can be superimposed on the reflection of the resonator when the resonant frequency of the resonator is increased, thus undesirably degrading the reflection characteristic of the resonator. In addition, since it is necessary to mount the coupling capacitor, the manufacturing process becomes complicated to reduce the productivity.

Disclosure of Invention

In view of the above problems of the related arts, it is an object of the present invention to provide a high-frequency oscillator circuit and a transmitter-receiver using the high-frequency oscillator circuit each of which has a small phase noise and high temperature stability and that is compact and capable of reducing the manufacturing cost.

(1) In order to resolve the above problems, the present invention provides a high-frequency oscillator circuit including a resonant circuit that reflects a high-frequency signal having a predetermined frequency and a negative resistance circuit that is connected to the resonant circuit and that amplifies the high-frequency signal and outputs the amplified signal. The high-frequency oscillator circuit is characterized in that the resonant circuit includes a resonator that resonates at a predetermined frequency; a coupling electrode that is provided near the resonator and is electrically coupled to the resonator; a main line which is provided near the coupling electrode on a circuit board, the one end of which is connected to the negative resistance circuit, and the other end of which is connected to a terminating resistor; and an inductor that connects between the main line and the coupling electrode and in that an unnecessary resonant frequency due to an inductance of the inductor and a ground capacitance of the coupling electrode is set to a value lower than a resonant frequency of the resonator.
According to the present invention, the coupling electrode is provided near the resonator and the inductor is used to connect between the coupling electrode and the main line. Accordingly, the resonator is electrically coupled to the coupling electrode, and the coupling electrode and the inductor are used to couple the resonator to the main line. As a result, since the negative resistance circuit amplifies the high-frequency signal having a predetermined frequency, reflected by the resonator, and outputs the amplified signal, the resonant circuit and the negative resistance circuit can be used to form, for example, the bandwidth-reflection-type oscillator circuit.
In addition, since the unnecessary resonant frequency due to the inductance of the inductor and the ground capacitance of the coupling electrode is set so as be lower than the resonant frequency of the resonator, there is no interference of the unnecessary resonant frequency due to the inductor in a bandwidth near the resonant frequency of the resonator. Hence, an effect of a parasitic reactance caused by the inductor is reduced, so that the amount of reflection in a bandwidth near the resonant frequency of the resonator is reduced and the sharpness of the reflection characteristic (the Q value of the resonant circuit) is improved. The phase noise of the oscillator circuit is reduced and, therefore, the operation of the oscillator circuit is stabilized.
(2) According to the present invention, a branch line branched from the main line may be provided on the circuit board, and the inductor may be used to connect between the leading end of the branch line and the coupling electrode. In this case, since the branch line is added to the main line and the inductor is used to connect between the leading end of the branch line and the coupling electrode, the phase between the main line and the coupling electrode can be adjusted by using the branch line. Accordingly, when the resonator is viewed from the main line, the unnecessary resonant frequency due to the inductance of the inductor and the ground capacitance of the coupling electrode can be set in accordance with the length of the branch line and the unnecessary resonant frequency can be shifted toward lower frequencies. As a result, the unnecessary resonant frequency due to the inductor etc. can be set to a value lower than the resonant frequency of the resonator to prevent the interference of the unnecessary resonant frequency with the resonant frequency of the resonator and to improve the sharpness of the reflection characteristic and the like.
(3) According to the present invention, the resonator may have a dielectric substrate provided on the circuit board and a resonant electrode that is formed on the surface of the dielectric substrate and sets the resonant frequency. The coupling electrode may be a bonding pad that is positioned near the resonant electrode and that is formed on the surface of the dielectric substrate. The inductor may be a bonding wire that connects between the main line and the bonding pad.
With this structure, the resonant electrode is capacitively coupled to the bonding pad via the spacing between the resonant electrode and the bonding pad. Here, since both the resonant electrode and the bonding pad can be formed on the dielectric substrate by using a thin-film wiring technology, it is possible to set the outlines of the resonant electrode and the bonding pad and the dimension of the spacing with high precision. Consequently, a variation in the amount of coupling between the resonant electrode and the bonding pad is reduced and a variation in the resonant frequency of the resonator is suppressed.
Since the resonant electrode is formed on the surface of the dielectric substrate, a microstrip can be used as the resonant electrode to from a microstrip resonator. Accordingly, the structure of the resonator is simplified, the size of the resonator is reduced, and the profile of the resonance of the resonator is lowered. In addition, the manufacturing cost of the resonator is reduced.
The bonding wire, which is an inductor, is used to connect between the bonding pad and the main line, so that the resonator can be mounted on the circuit board having the main line, the negative resistance circuit, and so on provided thereon by die and wire bonding. Hence, the resonator can be mounted on the circuit board along with, for example, the active device of the negative resistance circuit, without introducing new devices, to reduce the manufacturing cost of the entire oscillator circuit.

(4) According to the present invention, it is preferable that multiple bonding wires, which are in parallel to each other, be provided between the main line and the bonding pad.

With this structure, a characteristic variation of the oscillator circuit due to the shape of the wire is reduced and the yield ratio of the oscillator circuit is improved.

(5) According to the present invention, the dielectric substrate preferably has a relative dielectric constant of at least around 20.

With this structure, it is possible to use the dielectric substrate having a higher dielectric constant to decrease the effective wavelength in the dielectric substrate and to reduce the resonator in size. Since the resonator can be formed separately from the circuit board having the main line and so on provided thereon, the dielectric substrate of the resonator can be made of a material having a higher dielectric constant, a low loss, and a desired temperature characteristic. Consequently, it is possible to form the resonator having a small size, a small loss, and a temperature characteristic that can compensate a variation in the temperature of the negative resistance circuit and to structure the compact high-frequency oscillator circuit having high temperature stability and a small phase noise.

(6) According to the present invention, it is preferable that the circuit board be a multi-layer substrate in which multiple insulating layers and at least one electrode layer are layered and that the resonator be provided in a cavity concaved in the multi-layer substrate.

With this structure, the profile of the entire oscillator circuit is lowered. In addition, since the electrode layer of the multi-layer substrate is exposed in the cavity, grounding the electrode layer allows the ground of the main line to be made common to the ground of the resonator to realize stable grounding. Furthermore, since there is no need to provide via holes for grounding, the manufacturing cost is reduced.

(7) According to the present invention, a branch line branched from the main line may be provided by the electrode layer inside the multi-layer substrate, and the inductor may be used to connect between the leading end of the branch line and the coupling electrode.

In this case, the branch line is formed by the electrode layer inside the multi-layer substrate, so that the effective wavelength of the high-frequency signal passing through the branch line is reduced. Accordingly, the length of the branch line is decreased to reduce the entire oscillator circuit in size.

(8) According to the present invention, a shielding case that covers the resonator and is grounded may be provided over the circuit board, and the shielding case may form a shielding space having a cutoff frequency higher than the resonant frequency of the resonator between the circuit board and the shielding case.

In this case, since the shielding case covering the resonator is provided over the circuit board, making the shielding case close to the resonant electrode of the resonator can increase the resonant frequency of the resonator. Hence, the resonant frequency can be varied in accordance with the shape or the like of the shielding case, and the oscillation frequency of the oscillator circuit can be easily adjusted. In addition, the shielding case forms the shielding space having a cutoff frequency higher than the resonant frequency of the resonator between the shielding case and the circuit board, so that it is possible to reduce the radiation from the resonator.

(9) According to the present invention, the shielding case preferably surrounds both the boding wire and the resonator. With this structure, even if a signal is radiated from the resonator and the bonding wire, the signal is not mixed in peripheral circuits and, therefore, an effect of the radiated signal on the characteristics of the circuit can be avoided. Accordingly, other circuits (for example, a drive circuit and a filter circuit), in addition to the resonant circuit and the negative resistance circuit, can be arranged on the circuit board with a high density to reduce the entire oscillator circuit in size.

(10) The high-frequency oscillator circuit according to the present invention may be used to form a transmitter-receiver, such as a communication system or a radar system.

With this structure, the phase noise in the oscillator circuit can be reduced to stabilize the operation of the oscillator circuit and to stabilize the characteristics of the entire transmitter-receiver. In addition, for example, a compact microstrip resonator having a simple structure and a bonding wire capable of being realized with the existing devices can be used to form the oscillator circuit, so that the entire system is reduced in size and the manufacturing cost of the oscillator circuit is reduced.

Brief Description of the Drawings

Fig. 1 is a circuit diagram showing a high-frequency oscillator circuit according to a first embodiment of the present invention.

Fig. 2 is a perspective view of a resonant circuit in Fig. 1.

Fig. 3 is a plan view showing the resonant circuit in Fig. 2.

Fig. 4 is a cross-sectional view of the resonant circuit taken along line IV-IV in Fig. 3.

Fig. 5 is an equivalent circuit showing a main line, a branch line, resonator, etc. in the resonant circuit.

Fig. 6 is a graph of characteristic lines showing a function Y1 of the branch line and a function Y2 of an inductance and a ground capacitance with respect to an angular velocity.

Fig. 7 is a graph of characteristic lines showing, along with a comparative example, the relationship between the reflection coefficient and the frequency of the resonant circuit.

Fig. 8 is a graph of enlarged characteristic lines in a bandwidth near the resonant frequency of the resonator, in the characteristic lines in Fig. 7.

Fig. 9 is a perspective view of a resonant circuit according to a second embodiment.

Fig. 10 is a cross-sectional view of the resonant circuit taken along line X-X in Fig. 9.

Fig. 11 is a plan view of a resonant circuit according to a third embodiment.

Fig. 12 is a cross-sectional view of the resonant circuit taken along line XII-XII in Fig. 11.

Fig. 13 is a perspective view of a resonant circuit according to a fourth embodiment.

Fig. 14 is a perspective view of a resonant circuit according to a fifth embodiment.

Fig. 15 is a plan view of the resonant circuit in Fig. 14.

Fig. 16 is a cross-sectional view of the resonant circuit taken along line XVI-XVI in Fig. 15.

Fig. 17 is a block diagram showing a radar system according to a sixth embodiment.

Reference Numerals

| | |
|---|---|
| 1 | high-frequency oscillator circuit |
| 2, 51 | circuit board |
| 3 | negative resistance circuit |
| 9 | resonant circuit |
| 10 | resonator |
| 11 | dielectric substrate |
| 12 | resonant electrode |
| 17 | coupling electrode |
| 18 | spacing |
| 19 | main line |
| 20 | terminating resistor |
| 21, 43, 63 | branch line |
| 21A | leading end |
| 22 | bonding wire |
| 31, 41, 61 | multi-layer substrate |
| 31A, 31B, 41A to 41C, 61A to 61C | insulating layer |
| 31C, 41D, 41E, 61D, 61E | electrode layer |
| 32 | cavity |
| 44, 64 | leading-end electrode portion |
| 53, 65 | shielding case |
| 54, 66 | shielding space |
| 71 | radar system (transmitter-receiver) |

Best Mode for Carrying Out the Invention

High-frequency oscillator circuits and a transmitter-receiver according to embodiments of the present invention will be described in detail with reference to the attached drawings.

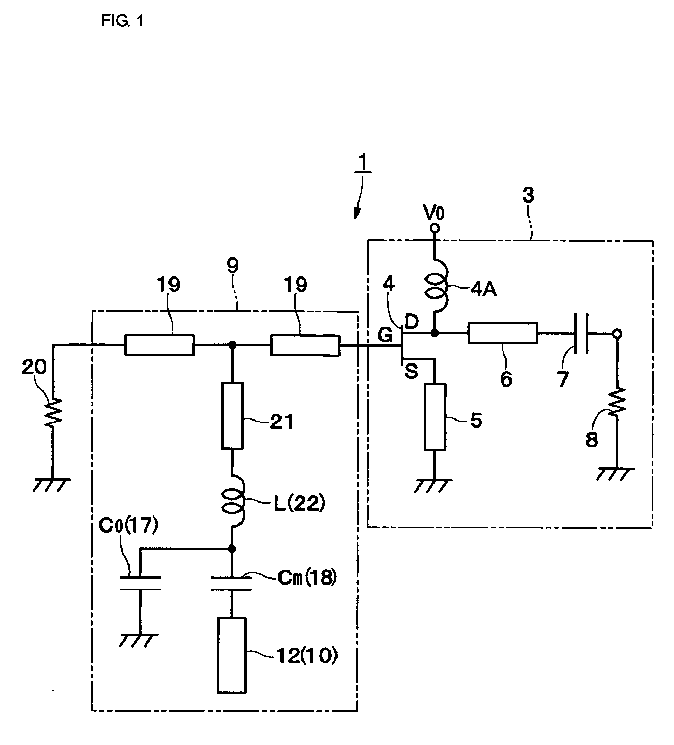

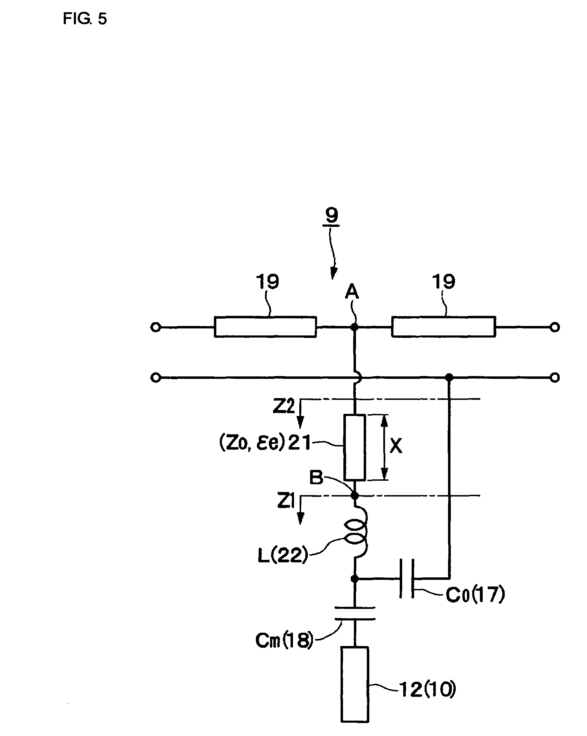

Figs. 1 to 8 show a first embodiment of the present invention. According to the first embodiment, a high-frequency oscillator circuit using a microstrip line will be exemplified.

Referring to Fig. 1, reference numeral 1 denotes the high-frequency oscillator circuit. The high-frequency oscillator circuit 1 includes a resonant circuit 9 mounted on, for example, a circuit board 2, described below, and a negative resistance circuit 3 that is mounted on the circuit board 2 along with the resonant circuit 9 and that amplifies a high-frequency signal reflected by the resonant circuit 9.

The circuit board 2 has a planer shape and is made of, for example, an insulative resin or ceramic material having a thickness of 0.1 to 0.2 mm and a relative dielectric constant of 2 to 13. The negative resistance circuit 3 includes a field effect transistor 4 (hereinafter referred to as an FET 4) serving as a high-frequency active device, a short stub 5 connected to a source terminal S of the FET 4, and a load 8 connected to a drain terminal D of the FET 4 via a transmission line 6 and a capacitor 7. The resonant circuit 9 is connected to a gate terminal G of the FET 4. In response to a drive voltage V0 applied to the drain terminal D through a choke inductor 4A, the negative resistance circuit 3 amplifies a high-frequency signal having a predetermined frequency, supplied from the resonant circuit 9, and outputs the amplified high-frequency signal through the drain terminal D. A direct-current (DC) component of the high-frequency signal output through the drain terminal D is removed by the capacitor 7 and the high-frequency signal after the removal of the DC component is supplied to the load 8.

Reference numeral 9 denotes a bandwidth-reflection-type resonant circuit, which reflects a high-frequency signal having a predetermined frequency that is set in advance and outputs the reflected high-frequency signal. The resonant circuit 9 includes a resonator 10, a coupling electrode 17, a main line 19, and so on, described below.

Reference numeral 10 denotes a resonator that resonates at a predetermined frequency of, for example, about 24 GHz. The resonator 10 includes a dielectric substrate 11 provided on the surface of the circuit board 2 and a resonant electrode 12 that is formed on the surface of the dielectric substrate 11 and sets a resonant frequency. The dielectric substrate 11 has a thickness of, for example, 0.2 to 0.5 mm and a relative dielectric constant $\varepsilon r$ of 20 to 100. The dielectric substrate 11 is formed in a chip having a substantially rectangular shape and is made of, for example, a ceramic material. The temperature coefficients (the temperature coefficient and the thermal expansion coefficient of the dielectric constant) of the dielectric material of the dielectric substrate 11 are selected so as to compensate the temperature characteristic of the negative resistance circuit 3.

The resonant electrode 12 is a microstrip line that is provided on the surface of the dielectric substrate 11 and that is formed of a conductive metallic thin-film strip. The resonant electrode 12 has a length Xr ($Xr \approx \lambda g/2$) that is appropriately half of an effective wavelength $\lambda g$ in the dielectric substrate 11, corresponding to the resonant frequency. Accordingly, the resonator 10 forms a half-wavelength ($\lambda g/2$) microstrip resonator.

On the rear face of the dielectric substrate 11, a ground electrode 13 is formed substantially over the resonant electrode 12. The ground electrode 13 is on a ground electrode 14 provided on the surface of the circuit board 2. The ground electrode 13 is adhered to the ground electrode 14 with a conductive material, such as a conductive paste or solder. The ground electrode 14 provided on the surface of the circuit board 2 is connected to a ground electrode 16, which provided on the rear face of the circuit board 2, via multiple via holes 15 and is grounded via the ground electrode 16.

Reference numeral 17 denotes a coupling electrode that is positioned near the resonant electrode 12 and that is formed on the surface of the dielectric substrate 11. The coupling electrode 17 is formed of a conductive metallic thin film, like the resonant electrode 12, and serves as a bonding pad to which bonding wires 22, described below, are joined. A spacing 18 having a predetermined dimension is formed between the resonant electrode 12 and the coupling electrode 17. Hence, the coupling electrode 17 is capacitively coupled to the resonant electrode 12 via a capacitance Cm of the spacing 18, and the amount of coupling between the coupling electrode 17 and the resonant electrode 12 is set in accordance with a dimension $\delta$ of the spacing 18. The coupling electrode 17 has a ground capacitance C0 between the ground electrode 13 and the coupling electrode 17. The ground capacitance C0 increases with, for example, an increase in the area of the coupling electrode 17.

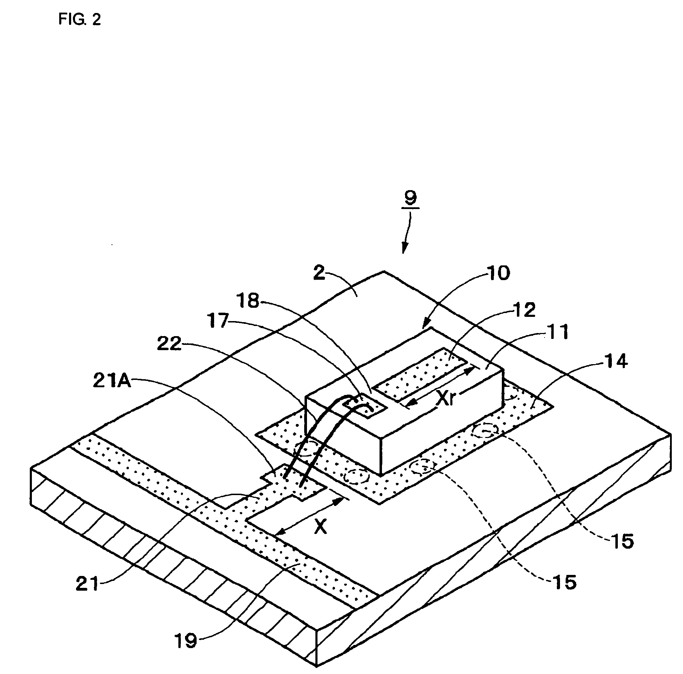

Although the resonant electrode 12 is substantially in parallel to and is opposed to the coupling electrode 17 in Figs. 2 to 4, the present invention is not limited to this arrangement. For example, the resonant electrode 12 and the coupling electrode 17 may be formed in interdigital electrodes and the interdigital coupling electrode 17 may be engaged with and opposed to the interdigital resonant electrode 12. This structure can increase the capacitance Cm between the resonant electrode 12 and the coupling electrode 17 to increase the amount of coupling.

Reference numeral 19 denotes a main line provided on the surface of the circuit board 2. The main line 19 is positioned near the coupling electrode 17 (resonator 10) and is provided on the surface of the circuit board 2. The main line 19 is a microstrip line formed of a conductive metallic thin-film strip. The main line 19 extends substantially straight and has a characteristic impedance of, for example, about 50 $\Omega$. One end of the main line 19 is connected to the gate terminal G of the FET 4 in the negative resistance circuit 3 and the other end thereof is connected to a terminating resistor 20.

The terminating resistor 20 may be an element, such as a chip resistor, mounted on the circuit board 2 or may be a film resistor applied or printed on the circuit board 2.

Reference numeral 21 denotes a branch line branched from the main line 19. The branch line 21 is a microstrip line provided on the surface of the circuit board 2, like the main line 19. The branch line 21 branches from an intermediate position of the main line 19 and extends orthogonally to the main line 19 and toward the resonator 10. The leading end 21A of the branch line 21 is arranged apart from the ground electrode 14 on the circuit board 2 and is connected to the coupling electrode 17 with the bonding wires 22, described below. The branch line 21 adjusts the phase between the main line 19 and the coupling electrode 17 in accordance with a length X of the branch line 21.

Reference numeral 22 denotes bonding wires serving as inductors connecting between the main line 19 and the coupling electrode 17. Multiple bonding wires 22 (only two of the bonding wires 22 are shown the drawings), which are in parallel to each other, are provided between the main line 19 and the coupling electrode 17. The bonding wires 22 are joined to the leading end 21A of the branch line 21 and to the coupling electrode 17 provided on the dielectric substrate 11 of the resonator 10. Each of the bonding wires 22 is formed in a strip that is made of a conductive metallic material, such as gold, and that has a diameter of 20 to 30 $\mu$m.

The bonding wires 22 have an inductance L between the leading end 21A of the branch line 21 and the coupling electrode 17 as a whole. The inductance L increases with an increase in the length of the bonding wires 22 and decreases with an increase in the number of the bonding wires 22.

The inductance L of the bonding wires 22 and the ground capacitance C0 of the coupling electrode 17 are connected in series between the intermediate position of the main line 19 and the ground. Accordingly, unnecessary resonance occurs due to the inductance L and the ground capacitance C0 to possibly degrade the frequency characteristic (reflection characteristic) of the resonator 10. Consequently, according to the first embodiment, the phase between the main line 19 and the coupling electrode 17 is adjusted by using the branch line 21, and the unnecessary resonant frequency due to the inductance L and the ground capacitance C0 as seen from the main line 19 is set to a value lower than the resonant frequency of the resonator 10. Specifically, the length and the number of the bonding wires 22, the area of the coupling electrode 17, the length X of the branch line, etc. are appropriately adjusted to set the unnecessary resonant frequency to a value lower than the resonant frequency of the resonator 10.

The operation of the high-frequency oscillator circuit 1 having the above structure, according to the first embodiment, will now be described.

When the drive voltage V0 is applied to the drain terminal D of the negative resistance circuit 3, a high-frequency signal having a frequency corresponding to the resonant frequency of the resonator 10 is supplied to the gate terminal G of the FET 4 through the main line 19. At this time, the negative resistance circuit 3 and the resonant circuit 9 form a bandwidth-reflection-type oscillator circuit. Accordingly, the FET 4 amplifies the signal having a frequency corresponding to the resonant frequency of the resonator 10 and externally outputs the amplified signal through the transmission line 6 and the capacitor 7.

Since the resonator 10 is connected to the main line 19 via the coupling electrode 17 and the bonding wires 22, unnecessary resonance due to the inductance L and the ground capacitance C0 can occur along with the resonance of the resonator 10. Accordingly, according to the first embodiment, the branch line 21 and so on are used to set the unnecessary resonant frequency due to the inductance L and the ground capacitance C0 as soon from the main line 19 to a value lower than the resonant frequency of the resonator 10.

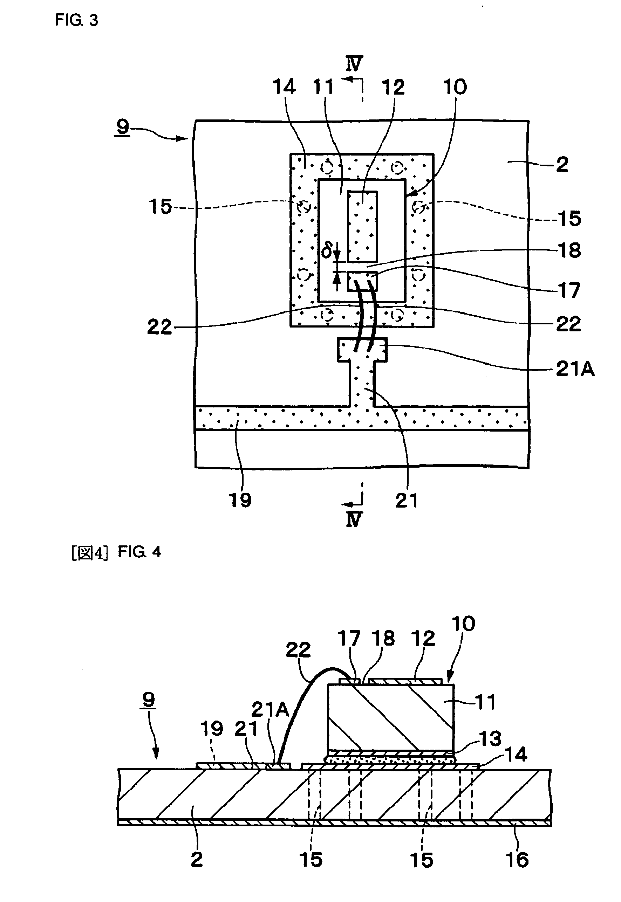

The relationship between the branch line 21 and the unnecessary resonant frequency (an angular velocity $\omega 1$) due to the inductance L and the ground capacitance C0 as seen from the main line 19 will be considered with reference to an equivalent circuit shown in Fig. 3. In order to simplify the analytic model, the capacitance Cm of the resonator 10 and the spacing 18 between the coupling electrode 17 and the resonant electrode 12, in Fig. 3, is ignored.

An impedance Z2 when the resonator 10 is viewed from a branch point A between the main line 19 and the branch line 21 is expressed by Formula 1 with respect to an angular velocity $\omega$.

[Formula 1]

$$Z2 = \frac{Z1 + j\, Z0 \tan\theta}{Z0 + j\, Z1 \tan\theta}$$

where

$$\theta = \frac{\sqrt{\varepsilon e}}{v}\,\omega\, X$$

$$Z1 = j\left(\omega\, L - \frac{1}{\omega\, C0}\right)$$

Reference letter and numeral Z0 denotes a characteristic impedance of the branch line 21 and reference letter and numeral Z1 denotes an impedance when the inductance L and the ground capacitance C0 are viewed from the leading end 21A (connection point B) of the branch line 21. Reference letters $\varepsilon e$ denotes an effective dielectric constant of the branch line 21, reference letter X denotes a length of the branch line 21, and reference letter v denotes a velocity of light.

The angular velocity ω (ω = 2πf) at which the impedance Z2 at the branch point A is equal to zero (Z2 = 0) satisfies the relationship in Formula 2.

[Formula 2]

$$Z0 \tan\left(\frac{\sqrt{\varepsilon e}}{v}\omega X\right) = \frac{1}{\omega C0} - \omega L$$

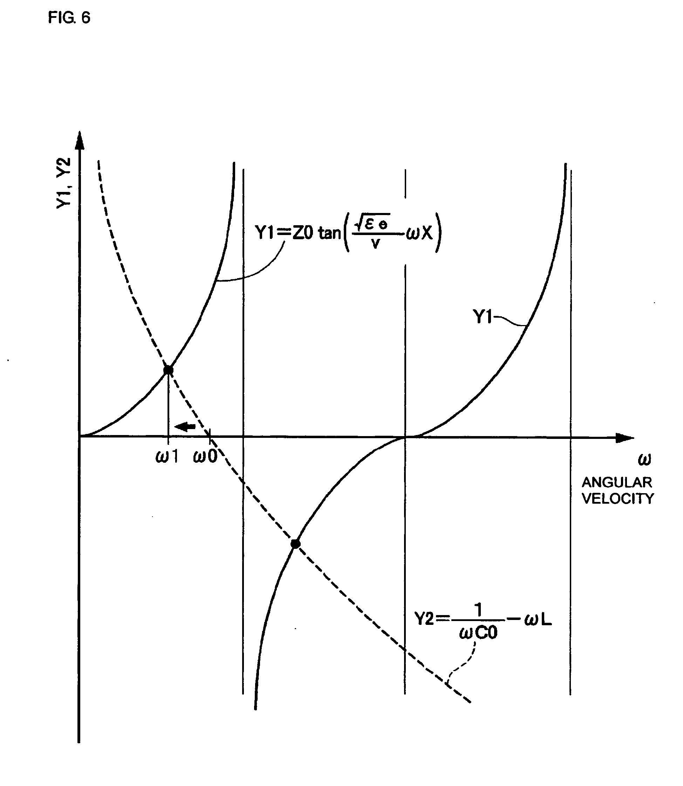

When the left and right sides of Formula 2 are functions Y1 and Y2, respectively, of the angular velocity ω, a result shown in Fig. 6 is yielded. The intersections of the functions Y1 and Y2 are the solutions of Formula 2, and these solutions (angular velocity ω1) correspond to the unnecessary resonant frequencies.

Fig. 6 shows that the unnecessary resonant frequency (angular velocity ω1) with the branch line 21 being added is shifted toward lower frequencies, compared with the unnecessary resonant frequency (angular velocity ω0) without the branch line 21 being added (X = 0). Accordingly, even if the unnecessary resonant frequency without the branch line 21 being added has a value closer to the resonant frequency of the resonator 10, adding the branch line 21 can shift the unnecessary resonant frequency toward lower frequencies.

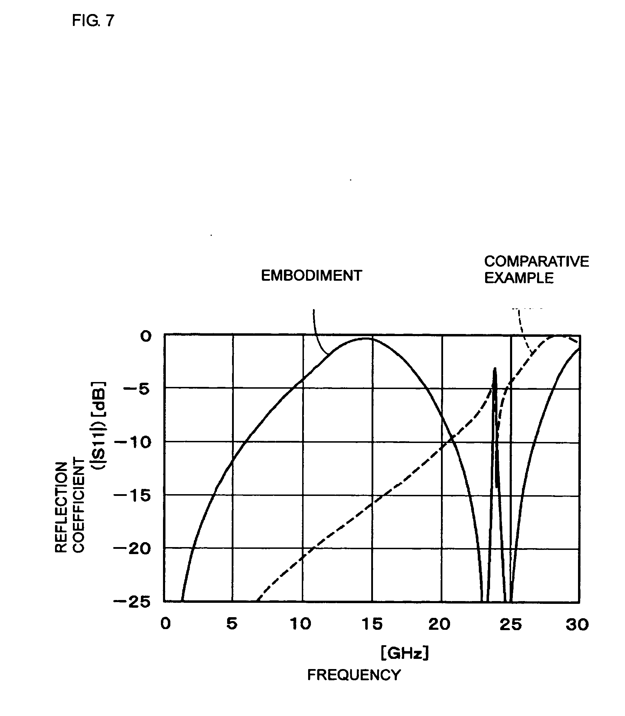

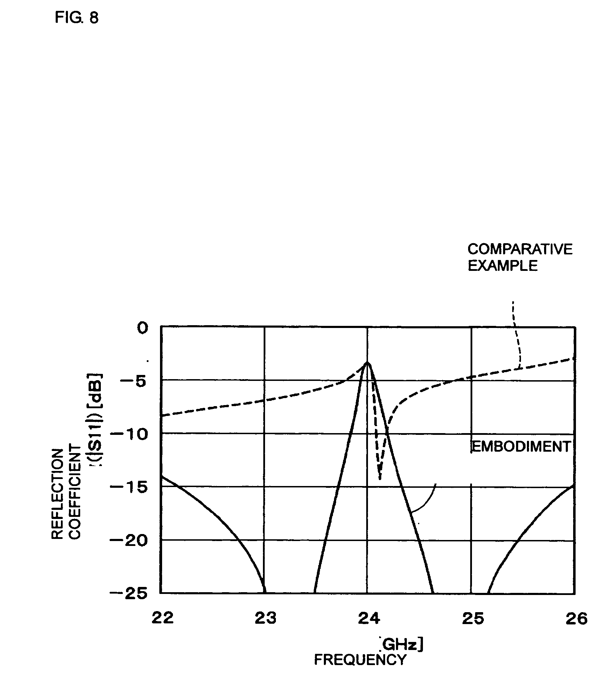

As a result, regarding a reflection coefficient S11 of the resonant circuit 9 with the branch line 21 being added, the amount of reflection near the resonant frequency (oscillation frequency) of the resonator 10 is reduced and thus a sharper reflection coefficient is yielded, compared with the case (a comparative example) without the branch line 21 being added, as shown in Figs. 7 and 8.

Specifically, in the comparative example shown by dashed lines in Figs. 7 and 8, when the resonant frequency of the resonator 10 is 24 GHz, the unnecessary resonant frequency due to the inductance L and the ground capacitance C0 without the branch line 21 being added is around 29 GHz and the reflection coefficient near the resonant frequency of the resonator 10 is -5 to -10 dB. Hence, since the resonant circuit 9 also reflects signals having frequencies other than the resonant frequency in the comparative example, there is a problem in that the oscillator circuit 1 outputs signals in a broad band near the resonant frequency of the resonator 10.

In contrast, the branch line 21 is added in the first embodiment, so that the unnecessary resonant frequency can be shifted toward lower frequencies, compared with the resonant frequency (24 GHz) of the resonator 10, as shown by solid lines in Figs. 7 and 8, and the unnecessary resonant frequency can be set to, for example, around 15 GHz. As a result, the reflection coefficient is reduced to a value not higher than -15 dB in a bandwidth (for example, 22 to 26 GHz) near the resonant frequency of the resonator 10. Consequently, a sharper reflection characteristic is yielded and the oscillator circuit 1 outputs signals in a narrow band near the resonant frequency of the resonator 10.

Since the frequency characteristic of the branch line 21 has periodicity, the impedance Z2 at the branch point A also has the periodicity and multiple unnecessary resonant frequencies exist (the intersections of functions Y1 and Y2 in Fig. 6). In this case, the reflection coefficient S11 (the reflection coefficient when the resonant frequency on the basis of the resonator 10 is excluded) of the resonant circuit 9 due to the impedance Z2 repeatedly has higher values near 0 dB and values lower than -20 dB when the frequency is varied from lower values to higher values. Accordingly, it is preferable that the ground capacitance C0 of the coupling electrode 17, the inductance L of the bonding wires 22, the length of the branch line 21, etc. be set such that the resonant frequency of the resonator 10 coincides with a frequency at which the reflection coefficient S11 due to the impedance Z2 is lower than, for example, -20 dB.

According to the first embodiment, the coupling electrode 17 is provided near the resonant electrode 12 and the bonding wires 22 are used to connect between the coupling electrode 17 and the main line 19. Accordingly, the resonant electrode 12 is capacitively coupled to the coupling electrode 17 and the coupling electrode 17 and the bonding wires 22 are used to couple the resonator 10 to the main line 19. As a result, since the negative resistance circuit 3 amplifies a high-frequency signal having a predetermined frequency, reflected by the resonator 10, and outputs the amplified signal, the resonant circuit 9 and the negative resistance circuit 3 can be used to form, for example, the bandwidth-reflection-type oscillator circuit 1.

In addition, since the unnecessary resonant frequency due to the inductance L of the bonding wires 22 and the ground capacitance C0 of the coupling electrode 17 is set so as to be lower than the resonant frequency of the resonator 10, there is no interference of the unnecessary resonant frequency in a bandwidth near the resonant frequency of the resonator 10. Hence, an effect of a parasitic reactance caused by the bonding wires 22 is reduced, so that the amount of reflectance in a bandwidth near the resonant frequency of the resonator 10 is reduced and the sharpness of the reflection characteristic (the Q value of the resonant circuit) is improved. In addition, since the phase noise of the oscillator circuit 1 is reduced, the operation of the oscillator circuit 1 is stabilized.

Particularly, since the branch line 21 is added to the main line 19 and the bonding wires 22 are used to connect between the leading end 21A of the branch line 21 and the coupling electrode 17 in the first embodiment, the phase between the main line 19 and the coupling electrode 17 can be adjusted by using the branch line 21. Accordingly, when the resonator 10 is viewed from the main line 19, the unnecessary resonant frequency due to the inductance L of the bonding wires 22 and the ground capacitance C0 of the coupling electrode 17 can be set in accordance with the length X of the branch line 21 and the unnecessary resonant frequency can be shifted toward lower frequencies. As a result, the unnecessary resonant frequency can be set to a value lower than the resonant frequency of the resonator 10 to prevent the interference of the unnecessary resonant frequency with the resonant frequency of the resonator 10 and to improve the sharpness of the reflection characteristic and the like.

The resonator 10 has the resonant electrode 12 formed on the surface of the dielectric substrate 11, and the coupling electrode 17 is formed of the bonding pad near the resonant electrode 12 on the surface of the dielectric substrate 11. Accordingly, the resonant electrode 12 is capacitively coupled to the coupling electrode 17 via the spacing 18 between the resonant electrode 12 and the coupling electrode 17. Here, since both the resonant electrode 12 and the coupling electrode 17 can be formed on the dielectric substrate 11 by using a thin-film wiring technology, it is possible to set the outlines of the resonant electrode 12 and the coupling electrode 17 and the dimension δ of the spacing 18 with high precision. Consequently, a variation in the amount of coupling between the resonant electrode 12 and the coupling electrode 17 is reduced and a variation in the resonant frequency of the resonator 10 is suppressed.

Since the resonant electrode 12 is formed on the surface of the dielectric substrate 11, a microstrip can be used as the resonant electrode 12 to from a microstrip resonator. Accordingly, the structure of the resonator 10 is simplified, the size of the resonator 10 is reduced, and the profile of the resonance of the resonator 10 is lowered. In addition, the manufacturing cost of the resonator 10 is reduced.

The bonding wires 22, which are inductors, are used to connect between the coupling electrode 17 and the main line 19, so that the resonator 10 can be mounted on the circuit board 2 having the main line 19, the negative resistance circuit 3, and so on provided thereon by die and wire bonding. Hence, the resonator 10 can be mounted on the circuit board 2 along with, for example, the active device (FET 4) of the negative resistance circuit 3, without introducing new devices, to reduce the manufacturing cost of the entire oscillator circuit 1.

Since the multiple bonding wires 22, which are in parallel to each other, are provided between the main line 19 and the coupling electrode 17, a characteristic variation of the oscillator circuit 1 due to the shape of the wire is reduced and the yield ratio of the oscillator circuit 1 is improved.

Furthermore, since the dielectric substrate 11 has a relative dielectric constant εr of at least around 20, it is possible to use the dielectric substrate 11 having a higher dielectric constant to decrease the effective wavelength in the dielectric substrate 11 and to reduce the resonator 10 in size. Since the resonator 10 can be formed separately from the circuit board 2 having the main line 19 and so on provided thereon, the dielectric substrate 11 can be made of a material having a higher dielectric constant, a low loss, and a desired temperature characteristic. Consequently, it is possible to form the resonator 10 having a small size, a small loss, and a temperature characteristic that can compensate a variation in the temperature of the negative resistance circuit 3 and to structure the compact high-frequency oscillator circuit 1 having high temperature stability and a small phase noise.

The branch line 21 is used to set the unnecessary resonant frequency due to the inductance L of the bonding wires 22 and the ground capacitance C0 of the coupling electrode 17 to a value lower than the resonant frequency of the resonator 10 in the first embodiment. However, the present invention is not limited to the above structure and the branch line 21 may be omitted. In such a case, the length and number of the bonding wires 22, the area of the coupling electrode 17, etc. are adjusted to set the unnecessary resonant frequency to a value lower than the resonant frequency of the resonator 10.

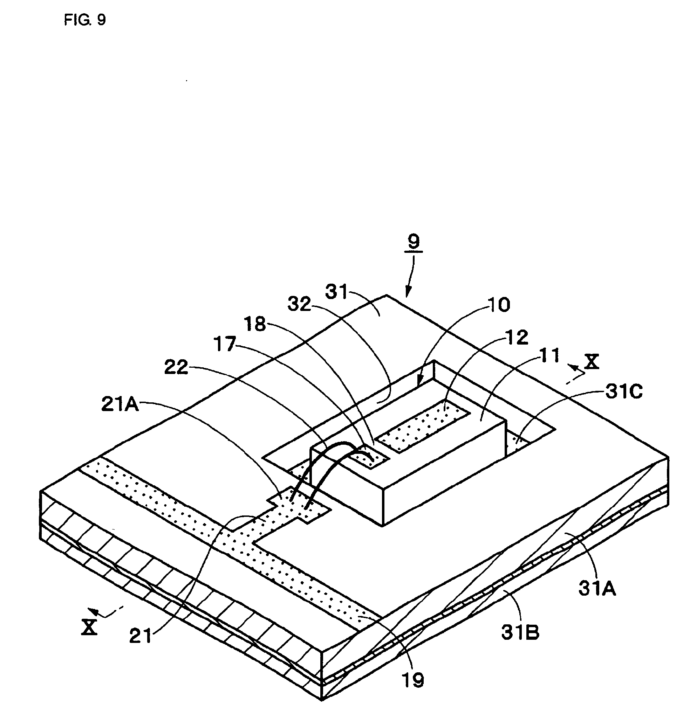

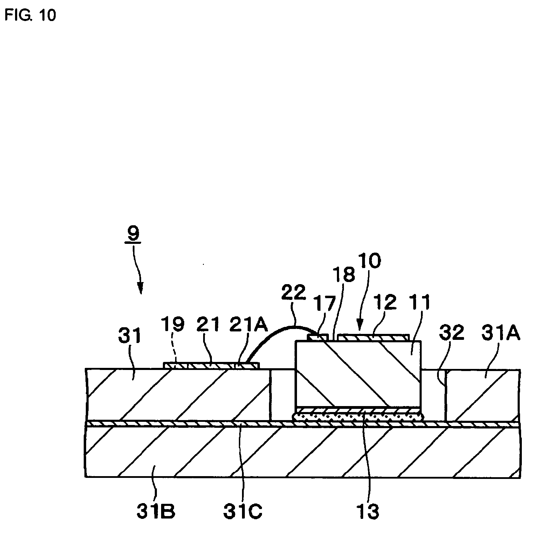

Figs. 9 and 10 show a second embodiment of the present invention. The second embodiment is characterized in that a multi-layer substrate in which multiple insulating and electrode layers are layered is used as the circuit board and in that a resonator is provided in a cavity concaved in the multi-layer substrate. The same reference numerals are used in the second embodiment to identify the same components in the above first embodiment. A description of such component is omitted herein.

Reference numeral 31 denotes a multi-layer substrate serving as a circuit board. The multi-layer substrate 31 is formed by layering two insulating layers 31A and 31B made of a ceramic material, such as alumina, or a resin material and one electrode layer 31C formed of a conductive metallic thin film. The electrode layer 31C is sandwiched between the insulating layers 31A and 31B and serves as a ground electrode that is grounded. In addition to a main line 19 and a branch line 21, a terminating resistor and a negative resistance circuit (not shown) are provided on the surface of the multi-layer substrate 31.

Reference numeral 32 denotes a cavity concaved in the multi-layer substrate 31. The cavity 32 is positioned near the leading end 21A of the branch line 21 and is provided on the surface of the multi-layer substrate 31. The cavity 32 passes through the insulating layer 31A at the surface side of the multi-layer substrate 31. The electrode layer 31C is exposed in the cavity 32.

A resonator 10 is housed in the cavity 32. A coupling electrode 17 provided on the surface of the resonator 10 is connected to the leading end 21A of the branch line 21 with bonding wires 22. A ground electrode 13 provided on the rear face of the resonator 10 is adhered to the electrode layer 31C with a conductive adhesive, solder, or the like. Accordingly, the ground electrode 13 of the resonator 10 is grounded via the electrode layer 31C.

With the structure described above, the second embodiment has approximately the same advantages as in the first embodiment. Particularly, according to the second embodiment, the resonator 10 is provided in the cavity 32 concaved in the multi-layer substrate 31, so that the profile of the entire oscillator circuit is lowered. In addition, since the electrode layer 31C of the multi-layer substrate 31 is exposed in the cavity 32, grounding the electrode layer 31C allows the ground of the main line 19 to be made common to the ground of the resonator 10 to realize stable grounding. Furthermore, since there is no need to provide via holes for grounding, the manufacturing cost is reduced.

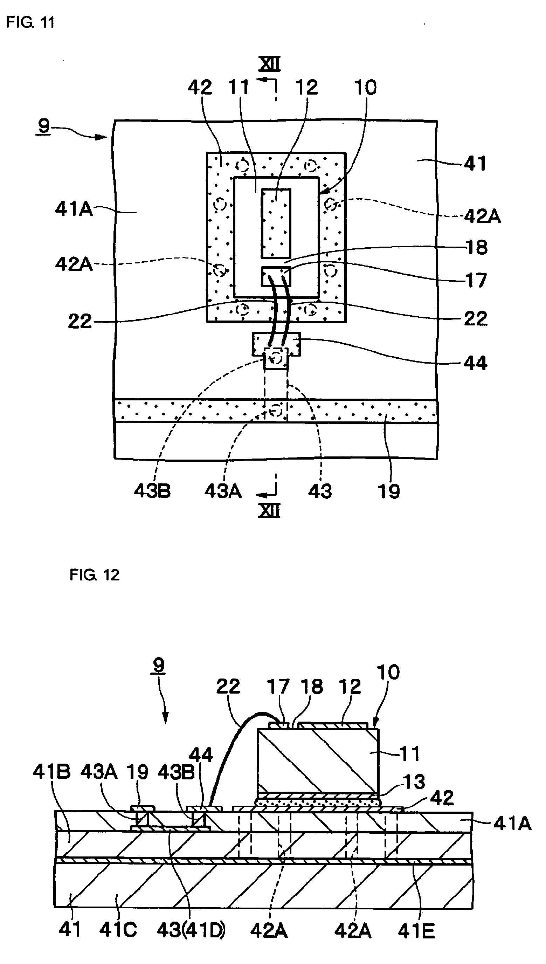

Figs. 11 and 12 show a third embodiment of the present invention. The third embodiment is characterized in that a branch line is formed in an electrode layer inside a multi-layer substrate. The same reference numerals are used in the third embodiment to identify the same components in the above first embodiment. A description of such component is omitted herein.

Reference numeral 41 denotes a multi-layer substrate serving as a circuit board. The multi-layer substrate 41 is formed by layering three insulating layers 41A to 41C made of a ceramic material, such as alumina, or a resin material and two electrode layers 41D and 41E formed of a conductive metallic thin film. The electrode layer 41D is sandwiched between the insulating layers 41A at the surface side and the intermediate insulating layer 41B. A branch line 43, described below, is formed by the electrode layer 41D. The electrode layer 41E is sandwiched between the intermediate insulating layer 41B and the insulating layer 41C at the rear-face side and serves as a ground electrode that is grounded. In addition to a ground electrode 42 and a main line 19, a terminating resistor and a negative resistance circuit (not shown) are provided on the surface of the multi-layer substrate 41. The ground electrode 42 is connected to the electrode layer 41E via multiple via holes 42A.

Reference numeral 43 denotes a branch line embedded in the multi-layer substrate 41. The branch line 43 is a strip line formed by the electrode layer 41D inside the multi-layer substrate 41. The bottom end of the branch line 43 is opposed to an intermediate position of the main line 19 and is connected to the main line 19 via a via hole 43A, and the leading end of the branch line 43 extends toward a position near the resonator 10. A leading-end electrode portion 44 serving as a bonding pad is provided on the surface of the multi-layer substrate 41. The leading end of the branch line 43 is connected to the leading-end electrode portion 44 via a via hole 43B, and the leading-end electrode portion 44 is connected to a coupling electrode 17 on the resonator 10 via bonding wires 22.

With the structure described above, the third embodiment has approximately the same advantages as in the first embodiment. Particularly, according to the third embodiment, the branch line 43 is formed by the electrode layer 41D inside the multi-layer substrate 41, so that the effective wavelength of the high-frequency signal passing through the branch line 43 is reduced. Accordingly, the length of the branch line 43 is decreased to reduce the entire oscillator circuit in size, compared with a case where the branch line 43 is formed on the surface of the multi-layer substrate 41.

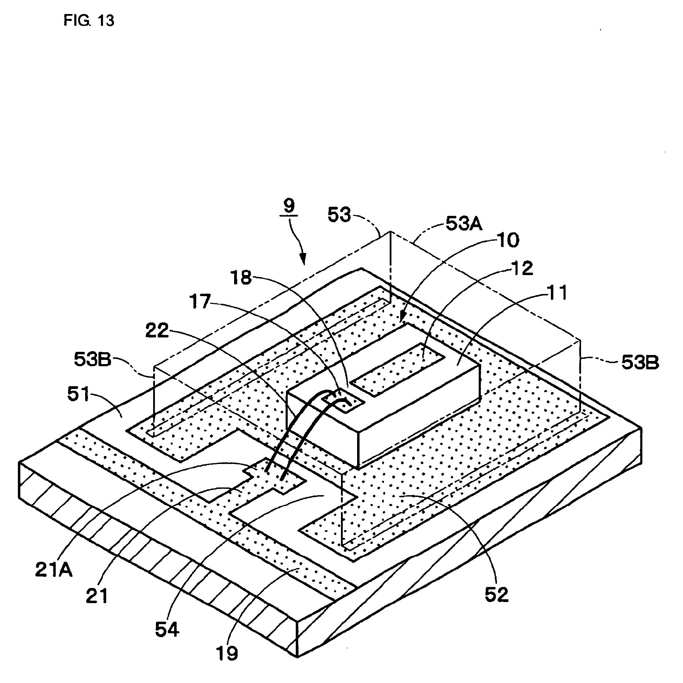

Fig. 13 shows a fourth embodiment of the present invention. The fourth embodiment is characterized in that a shielding case that covers a resonator and is grounded is provided over a circuit board and in that the shielding case forms a shielding space having a cutoff frequency higher than the resonant frequency of the resonator between the shielding case and the circuit board. The same reference numerals are used in the fourth embodiment to identify the same components in the above first embodiment. A description of such component is omitted herein.

Reference numeral 51 denotes a circuit board according to the fourth embodiment. The circuit board 51 is made of an insulative resin material, similarly to the circuit board 2 according to the first embodiment. In addition to a main line 19 and a branch line 21, a ground electrode 52 that is positioned near the leading end 21A of the branch line 21 and is grounded is formed on the surface of the circuit board 51. A resonator 10 is provided on the ground electrode 52 and a shielding case 53, described below, is adhered to the ground electrode 52.

Reference numeral 53 denotes a shielding case that is provided over the surface of the circuit board 51 and that is made of, for example, a conductive metallic material. The shielding case 53 is formed so as to have a substantially horseshoe-shaped cross section and has a substantially rectangular top plate 53A and side plates 53B provided along the left and right sides of the top plate 53A. The shielding case 53 is mounted on the circuit board 51 over the resonator 10. The two side plates 53B are adhered to the ground electrode 52 with a conductive adhesive, solder, or the like.

The cross-sectional shape (the horizontal length of the top plate 53A, the height of the side plates 53B, etc.) of the shielding case 53 is set such that a shielding space 54 having a cutoff frequency higher than the resonant frequency of the resonator 10 is formed between the shielding case 53 and the circuit board 51. Accordingly, the shielding case 53 forms a cutoff waveguide along with the ground electrode 52 on the circuit board 51 such that no cavity resonance occurs in a bandwidth near the resonant frequency of the resonator 10. The resonant frequency occurring in the shielding case 53 is set so as to be higher than the resonant frequency of the resonator 10.

The entire oscillator circuit is covered with a metallic case or the like (not shown) provided separately from the shielding case 53.

With the structure described above, the fourth embodiment has approximately the same advantages as in the first embodiment. Particularly, since the shielding case 53 covering the resonator 10 is provided over the circuit board 51 in the fourth embodiment, for example, making the top plate 53A of the shielding case 53 close to the resonant electrode 12 of the resonator 10 can increase the resonant frequency of the resonator 10. Hence, the resonant frequency can be varied in accordance with the shape or the like of the shielding case 53, and the oscillation frequency of the oscillator circuit can be easily adjusted. In addition, the shielding case 53 forms the shielding space 54 having a cutoff frequency higher than the resonant frequency of the resonator 10 between the shielding case 53 and the circuit board 51, so that it is possible to reduce the radiation from the resonator 10 and to improve the operation stability of the oscillator circuit.

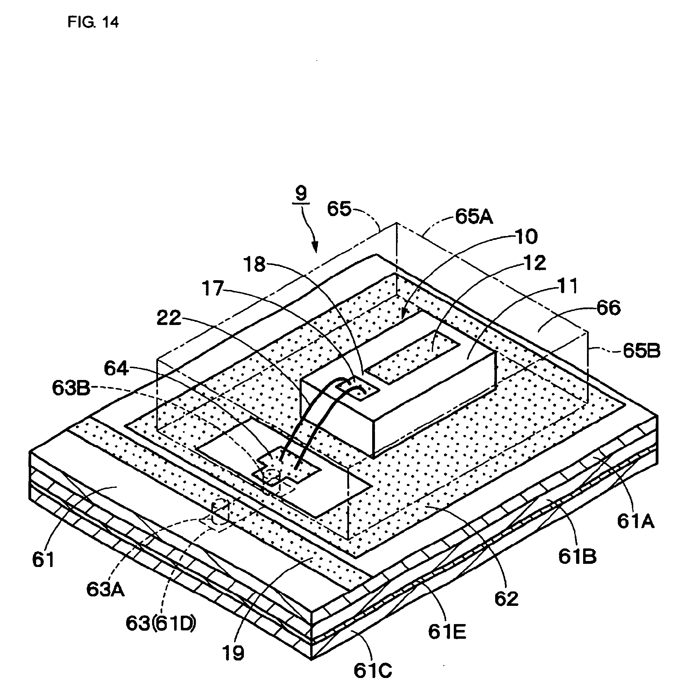

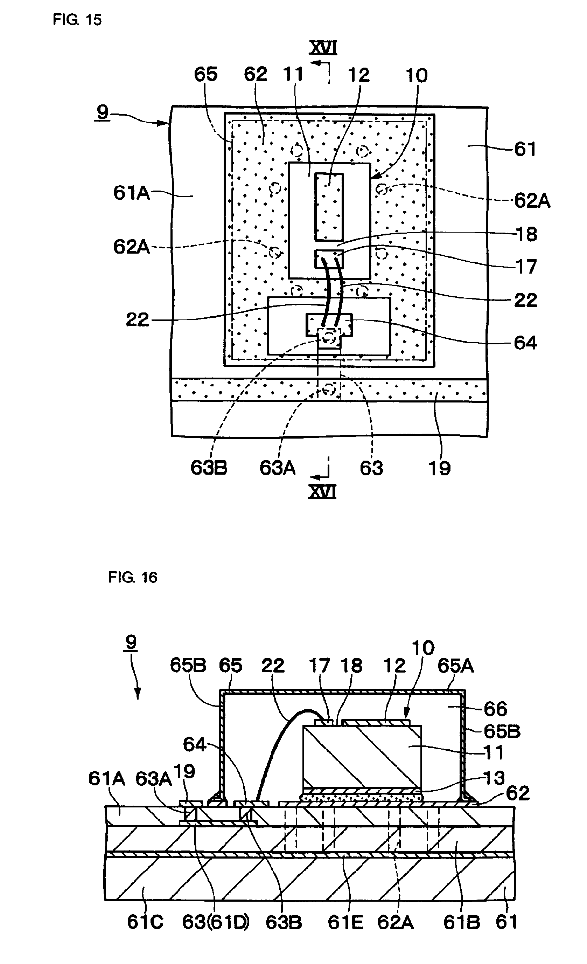

Figs. 14 to 16 show a fifth embodiment of the present invention. The fifth embodiment is characterized in that a shielding case that covers a resonator and is grounded is provided over a circuit board and in that the shielding case covers both bonding wires and the resonator. The same reference numerals are used in the fifth embodiment to identify the same components in the above first embodiment. A description of such component is omitted herein.

Reference numeral 61 denotes a multi-layer substrate serving as a circuit board. The multi-layer substrate 61 is formed by layering three insulating layers 61A to 61C made of a ceramic material, such as alumina, or a resin material and two electrode layers 61D and 61E formed of a conductive metallic thin film. The electrode layer 61D is sandwiched between the insulating layers 61A at the surface side and the intermediate insulating layer 61B. A branch line 63, described below, is formed by the electrode layer 61D. The electrode layer 61E is sandwiched between the intermediate insulating layer 61B and the insulating layer 61C at the rear-face side and serves as a ground electrode that is grounded. In addition to a main line 19, a terminating resistor and a negative resistance circuit (not shown) are provided on the surface of the multi-layer substrate 61.

Reference numeral 62 denotes a ground electrode provided on the surface of the multi-layer substrate 61. The ground electrode 62 surrounds a leading-end electrode portion 64 of a branch line 63, described below, and is connected to the electrode layer 61E, which is the ground electrode, via multiple via holes 62A. Accordingly, the ground electrode 62 is grounded via the electrode layer 61E. A resonator 10 is provided on the ground electrode 62 and a shielding case 65, described below, is adhered to the ground electrode 62.

The distance between the adjacent via holes 62A is set to a value smaller than half ($\lambda g/2$) of the effective wavelength $\lambda g$ in the multi-layer substrate 61, corresponding to the resonant frequency of the resonator 10.

Reference numeral 63 denotes a branch line embedded in the multi-layer substrate 61. The branch line 63 is a strip line formed by the electrode layer 61D inside the multi-layer substrate 61. The bottom end of the branch line 63 is opposed to an intermediate position of the main line 19 and is connected to the main line 19 via a via hole 63A, and the leading end of the branch line 63 extends toward a position near the resonator 10. The leading-end electrode portion 64 serving as a bonding pad is provided on the surface of the multi-layer substrate 61. The leading end of the branch line 63 is connected to the leading-end electrode portion 64 via a via hole 63B, and the leading-end electrode portion 64 is connected to a coupling electrode 17 on the resonator 10 via bonding wires 22.

Reference numeral 65 denotes a shielding case that is provided on the surface of the multi-layer substrate 61 and that is made of, for example, a conductive metallic material. The shielding case 65 is a substantially box-shaped case, the bottom side of which is open. The shielding case 65 is formed of a substantially rectangular top plate 65A and side plates 65B provided along the four sides of the top plate 65A. The shielding case 65 is mounted on the multi-layer substrate 61 over the resonator 10, the bonding wires 22, and so on. The four side plates 65B are adhered to the ground electrode 62 with a conductive adhesive, solder, or the like. The shielding case 65 forms a shielding space 66 between the shielding case 65 and the multi-layer substrate 61.

With the structure described above, the fifth embodiment has approximately the same advantages as in the first and third embodiments. Particularly, since the shielding case 65 is formed in a box shape surrounding both the resonator 10 and the bonding wires 22, a radiated signal can be held in the shielding space 66 even if the signal is radiated from the resonator 10 and the bonding wires 22. Hence, the signal radiated from the resonator 10 and so on is not mixed in peripheral circuits and, therefore, an effect on the characteristics of the circuit can be avoided. As a result, other circuits (for example, a drive circuit and a filter circuit), in addition to the resonant circuit 9 and the negative resistance circuit, can be arranged on the multi-layer substrate 61 with a high density to reduce the entire oscillator circuit in size.

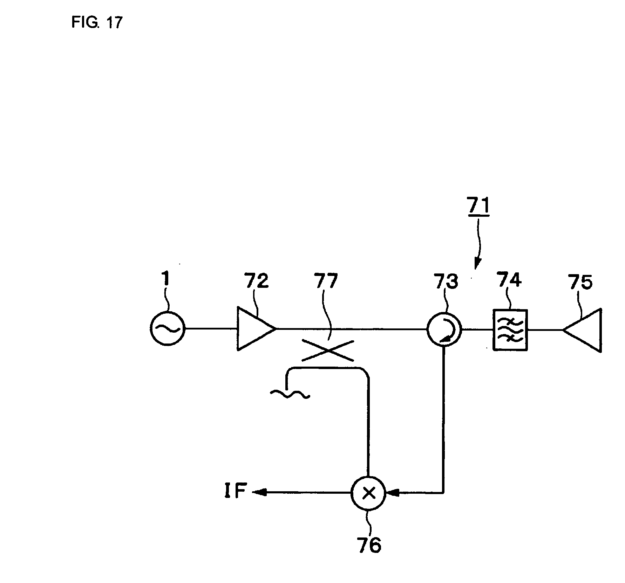

Fig. 17 shows a sixth embodiment of the present invention. The sixth embodiment is characterized in that the high-frequency oscillator circuit according to the present invention is used to form a radar system serving as a transmitter-receiver. The same reference numerals are used in the sixth embodiment to identify the same components in the above first embodiment. A description of such component is omitted herein.

Reference numeral 71 denotes a radar system. The radar system 71 mainly includes a high-frequency oscillator circuit 1 according to any of the first to fifth embodiments; an antenna unit 75 connected to the oscillator circuit 1 via an amplifier 72, a circulator 73, and a bandpass filter 74; and a mixer 76 connected to the circulator 73 in order to down-convert a signal received from the antenna unit 75 to an intermediate-frequency signal IF. A directional coupler 77 is connected between the amplifier 72 and the circulator 73. A signal whose power is distributed from the directional coupler 77 is supplied to the mixer 76 as a local signal.

The radar system 71 according to the sixth embodiment has the structure described above. A high-frequency signal supplied from the oscillator circuit 1 is amplified by the amplifier 72, passes through the directional coupler 77, the circulator 73, and the bandpass filter 74, and is transmitted through the antenna unit 75 as a transmission signal. In contrast, a reception signal received by the antenna unit 75 is supplied to the mixer 76 through the circulator 73, is down-converted with the local signal from the directional coupler 77, and is output as the intermediate-frequency signal IF.

According to the sixth embodiment, since the high-frequency oscillator circuit 1 is used to form the radar system 71, the phase noise in the oscillator circuit 1 can be reduced to stabilize the operation of the oscillator circuit 1 and to stabilize the characteristics of the entire radar system 71. In addition, for example, a compact microstrip resonator having a simple structure and bonding wires capable of being realized with the existing devices can be used to form the oscillator circuit 1, so that the entire system is reduced in size and the manufacturing costs of the oscillator circuit 1 and the radar system 71 are also reduced.

Although the oscillator circuit 1 according to the present invention is applied to the radar system 71 in the sixth embodiment, the oscillator circuit according to the present invention may be applied to, for example, a communication system as the transmitter-receiver.

Although the resonant electrode 12, which is the half-wavelength ($\lambda$g/2) microstrip line, is used in the above embodiments, the present invention is not limited to this structure. For example, a resonant electrode being a quarter-wavelength ($\lambda$g/4) microstrip line, which has a length that is equal to a quarter of one wavelength $\lambda$g, may be used. In this case, one of the longitudinal ends of the quarter-wavelength ($\lambda$g/4) microstrip line is made a short-circuited end that is grounded and the other end thereof is made an open end. The open end of quarter-wavelength ($\lambda$g/4) microstrip line is arranged near the coupling electrode.

Although the FET 4 is used as an active device of the negative resistance circuit 3 in the above embodiments, for example, a hetero-junction bipolar transistor (HBT) may be used. These active devices (the FET, the HBT, etc.) can be mounted by various methods including flip-flop mounting, solder mounting, or mounting with wires.

Although the shielding case 53 and the shielding case 65 are made of conductive metallic materials in the above fourth and fifth embodiments, an insulative box made of a resin material may be coated with a coating film made of a conductive material (for example, metal plating) to form a shielding case.

Although the resonator 10 is capacitively coupled to the coupling electrode 17 in the above embodiments, the present invention is not limited to this coupling. For example, the resonator may be coupled to the coupling electrode by another coupling method, such as direct coupling or magnetic coupling.

## Claims

1. A high-frequency oscillator circuit comprising a resonant circuit that reflects a high-frequency signal having a predetermined frequency and a negative resistance circuit that is connected to the resonant circuit and that amplifies the high-frequency signal and outputs the amplified signal,
   wherein the resonant circuit includes a resonator that resonates at a predetermined frequency; a coupling electrode that is provided near the resonator and is electrically coupled to the resonator; a main line which is provided near the coupling electrode on a circuit board, the one end of which is connected to the negative resistance circuit, and the other end of which is connected to a terminating resistor; and an inductor that connects between the main line and the coupling electrode, and
   wherein an unnecessary resonant frequency due to an inductance of the inductor and a ground capacitance of the coupling electrode is set to a value lower than a resonant frequency of the resonator.

2. The high-frequency oscillator circuit according to Claim 1, wherein a branch line branched from the main line is provided on the circuit board, and the inductor is used to connect between the leading end of the branch line and the coupling electrode.

3. The high-frequency oscillator circuit according to Claim 1,
   wherein the resonator has a dielectric substrate provided on the circuit board and a resonant electrode that is formed on the surface of the dielectric substrate and sets the resonant frequency,
   wherein the coupling electrode is a bonding pad that is positioned near the resonant electrode and that is formed on the surface of the dielectric substrate, and
   wherein the inductor is a bonding wire that connects between the main line and the bonding pad.

4. The high-frequency oscillator circuit according to Claim 3, wherein multiple bonding wires, which are in parallel to each other, are provided between the main line and the bonding pad.

**5.** The high-frequency oscillator circuit according to Claim 3, wherein the dielectric substrate has a relative dielectric constant of at least around 20.

**6.** The high-frequency oscillator circuit according to Claim 3,
wherein the circuit board is a multi-layer substrate in which multiple insulating layers and at least one electrode layer are layered, and
wherein the resonator is provided in a cavity concaved in the multi-layer substrate.

**7.** The high-frequency oscillator circuit according to Claim 6,
wherein a branch line branched from the main line is provided in the electrode layer inside the multi-layer substrate, and
wherein the inductor is used to connect between the leading end of the branch line and the coupling electrode.

**8.** The high-frequency oscillator circuit according to Claim 3, wherein a shielding case that covers the resonator and is grounded is provided over the circuit board, and the shielding case forms a shielding space having a cutoff frequency higher than the resonant frequency of the resonator between the circuit board and the shielding case.

**9.** The high-frequency oscillator circuit according to Claim 8, wherein the shielding case surrounds both the boding wire and the resonator.

**10.** A transmitter-receiver using the high-frequency oscillator circuit according to any of Claims 1 to 9.

FIG. 1

FIG. 2

FIG. 3

[図4] FIG. 4

FIG. 5

FIG. 6

$$Y1 = Z0 \tan\left(\frac{\sqrt{\varepsilon_\theta}}{v}\omega X\right)$$

Y1

Y1, Y2

$\omega$1 $\omega$0

$\omega$
ANGULAR
VELOCITY

$$Y2 = \frac{1}{\omega C0} - \omega L$$

FIG. 7

FIG. 8

COMPARATIVE
EXAMPLE

EMBODIMENT

REFLECTION COEFFICIENT ($|S11|$) [dB]

0
−5
−10
−15
−20
−25

22    23    24    25    26

[GHz]
FREQUENCY

FIG. 9

FIG. 10

FIG. 11

XII

42  11  12  10

9

41A

42A — 18

42A — 17

22 — 22

44

43B  43A  43  19

XII

FIG. 12

9

22  17  18  12  10

44  11

41B  43A  19  43B  13  42

41A

41  41C  43(41D)  42A  42A  41E

FIG. 13

FIG. 14

FIG. 15

FIG. 16

FIG. 17

**INTERNATIONAL SEARCH REPORT**

| International application No. |
| --- |
| PCT/JP2005/014207 |

A. CLASSIFICATION OF SUBJECT MATTER
*H03B5/18* (2006.01), *H01P7/08* (2006.01)

According to International Patent Classification (IPC) or to both national classification and IPC

B. FIELDS SEARCHED

Minimum documentation searched (classification system followed by classification symbols)
*H03B5/18* (2006.01), *H01P7/08* (2006.01), *H01P1/203* (2006.01)

Documentation searched other than minimum documentation to the extent that such documents are included in the fields searched
Jitsuyo Shinan Koho                1922-1996      Jitsuyo Shinan Toroku Koho     1996-2005
Kokai Jitsuyo Shinan Koho     1971-2005      Toroku Jitsuyo Shinan Koho     1994-2005

Electronic data base consulted during the international search (name of data base and, where practicable, search terms used)
WPI/L

C. DOCUMENTS CONSIDERED TO BE RELEVANT

| Category* | Citation of document, with indication, where appropriate, of the relevant passages | Relevant to claim No. |
| --- | --- | --- |
| Y<br>A | JP 2002-246815 A  (Matsushita Electric<br>Industrial Co., Ltd.),<br>30 August, 2002 (30.08.02),<br>Figs. 1, 2<br>(Family: none) | 1,3-6,8-10<br>2,7 |
| Y | JP 53-97757 A  (NEC Corp.),<br>26 August, 1978 (26.08.78),<br>Page 1, lower right column, lines 3 to 18<br>(Family: none) | 1,3-6,8-10 |
| Y | JP 2001-320170 A  (Mitsubishi Electric Corp.),<br>16 November, 2001 (16.11.01),<br>Par. No. [0005]<br>(Family: none) | 1,3-6,8-10 |

[X]  Further documents are listed in the continuation of Box C.          [ ]  See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>    19 October, 2005 (19.10.05) | Date of mailing of the international search report<br>    01 November, 2005 (01.11.05) |
| --- | --- |
| Name and mailing address of the ISA/<br>    Japanese Patent Office | Authorized officer |
| Facsimile No. | Telephone No. |

Form PCT/ISA/210 (second sheet) (April 2005)

**INTERNATIONAL SEARCH REPORT**

| International application No. |
| --- |
| PCT/JP2005/014207 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 2001-94377 A  (Matsushita Electric Industrial Co., Ltd.), 06 April, 2001 (06.04.01), Par. Nos. [0017], [0027]; Fig. 1 (Family: none) | 1,3-6,8-10 |
| Y | JP 63-31305 A  (Mitsubishi Electric Corp.), 10 February, 1988 (10.02.88), Fig. 1 (Family: none) | 1,3-6,8-10 |
| Y | JP 63-70601 A  (NEC Corp.), 30 March, 1988 (30.03.88), Figs. 1, 2 (Family: none) | 3,4 |
| Y | JP 2-215205 A  (Hitachi, Ltd.), 28 August, 1990 (28.08.90), Fig. 1 (Family: none) | 6 |
| Y | Microfilm of the specification and drawings annexed to the request of Japanese Utility Model Application No. 64755/1985(Laid-open No. 182098/1986) (Toshiba Corp.), 13 November, 1986 (13.11.86), Full text; all drawings (Family: none) | 8,9 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 6204747 A
- JP 11330818 A

- JP 63070601 A


### Non-patent literature cited in the description

- **YOUNG-TAEK LEE et al.** A Compact-Size Microstrip Spiral Resonator and Its Application to Microwave Oscillator. *IEEE MICROWAVE AND WIRELESS COMPONENTS LETTER,* October 2000, vol. 12 (10), 375-377